# FASCICULE DE BREVET EUROPEEN

(11) **EP 2 693 227 B1**
(45) Date de publication et mention de la délivrance du brevet: **04.09.2019**
(21) Numéro de dépôt: 13178446.4
(22) Date de dépôt: 30.07.2013
(51) Int. Cl.: G01R 31/08, G01R 31/02, G01R 27/16, H02H 5/10, H02H 1/00

(54) **Système de détection d'une variation d'impédance d'un conducteur de neutre, poste de transformation comprenant un tel système et procédé de detection d'une variation d'impédance d'un conducteur de neutre avec un tel système**
System zum Erfassen einer Impedanzänderung eines Nullleiters, Trafostation, die ein solches System umfasst, und Erfassungsverfahren einer Impedanzänderung eines Nullleiters mit einem solchen System
System for detecting an impedance variation in a neutral conductor, transformer station including such a system and method for detecting an impedance variation in a neutral conductor with such a system

(30) Priorité: 31.07.2012 FR 1257426
(43) Date de publication de la demande: 05.02.2014
(73) Titulaire: Schneider Electric Industries SAS, 92500 Rueil-Malmaison (FR)
(72) Inventeur: Clemence, Michel, 73000 CHAMBERY (FR); Contini, Erick, 38240 MEYLAN (FR)
(74) Mandataire: Lavoix

(56) Documents cités:
- WO-A1-2009/127068
- FR-A1- 2 747 197
- US-A1- 2006 176 631

## Description

La présente invention concerne un système de détection d'une variation d'impédance d'un conducteur de neutre d'un réseau électrique alternatif polyphasé, le réseau électrique comportant P conducteurs de phase et un conducteur de neutre, P étant un nombre entier supérieur à 1.

Ce système de détection comprend un groupe de P capteurs de tension, chaque capteur de tension étant propre à mesurer la tension d'un conducteur de phase respectif par rapport au conducteur de neutre, et un dispositif de supervision relié à chacun des capteurs de tension par une liaison de données.

La présente invention concerne également un poste de transformation électrique destiné à être connecté à un réseau électrique alternatif polyphasé, le poste de transformation comprenant P conducteurs de phase, un conducteur de neutre et un tel système de détection d'une variation d'impédance du conducteur de neutre.

La présente invention concerne également un procédé de détection d'une variation d'impédance d'un conducteur de neutre d'un réseau électrique alternatif polyphasé avec un tel système de détection.

On connaît du document US 2007/0258175 A1 un système de détection du type précité. Le système de détection comprend des moyens permettant de mesurer le déséquilibre en tension entre le premier conducteur et le conducteur de neutre d'une part, et entre un second conducteur et le conducteur de neutre d'autre part. Ce système est adapté pour un circuit électrique biphasé. Le système de détection comprend des moyens de comparaison du déséquilibre en tension par rapport à une valeur de seuil prédéterminée. Le système comprend des moyens permettant de générer une alarme si le déséquilibre en tension mesuré est supérieur ou inférieur à l'une des valeurs de seuil prédéterminée. Ainsi le système, en mesurant les tensions des deux conducteurs électriques de phase et en comparant des valeurs aux seuils prédéterminés, permet la génération d'une alarme relative à une rupture de neutre du circuit électrique instrumenté, tel qu'un tableau d'abonné.

Toutefois, un tel système de détection ne fournit pas d'information sur l'état du réseau électrique en dehors du tableau d'abonné.

Le but de l'invention est donc de proposer un système de détection propre à détecter une variation d'impédance du conducteur de neutre sur le réseau électrique, et à localiser cette variation de neutre le long du réseau.

A cet effet, l'invention a pour objet un système de détection de type précité, caractérisé en ce que :
- le système comprend en outre (N-1) autre(s) groupe(s) de P capteurs de tension, N étant un nombre entier supérieur à 1, les N groupes de capteurs de tension étant disposés en différents emplacements le long du réseau électrique, et en ce que
- le dispositif de supervision est propre à détecter, entre deux groupes successifs de capteurs, une variation de la tension d'un conducteur de phase donné par rapport au conducteur de neutre, afin de détecter une variation d'impédance du conducteur de neutre et de localiser ladite variation d'impédance entre les deux groupes successifs de capteurs.

Suivant d'autres aspects avantageux de l'invention, le système de détection comprend une ou plusieurs des caractéristiques suivantes, prises isolément ou suivant toutes les combinaisons techniquement possibles :
- chaque capteur de tension comporte des moyens d'émission d'un message d'alerte à destination du dispositif de supervision en cas de détection d'une surtension ou d'une sous-tension pour au moins un conducteur de phase ;
- chaque capteur de tension comporte des moyens de comparaison de la tension mesurée avec un seuil de surtension et un seuil de sous-tension prédéfinis, afin de détecter une surtension ou une sous-tension ;
- le dispositif de supervision comporte des moyens de comparaison de la tension mesurée, reçue d'un capteur de tension correspondant, avec un seuil de surtension et un seuil de sous-tension prédéfinis, afin de détecter une surtension ou une sous-tension ;
- le dispositif de supervision comporte des moyens de communication avec chacun des capteurs de tension, aptes à envoyer une requête à chacun des capteurs de tension afin de recevoir en réponse la tension mesurée par chaque capteur de tension ;
- le dispositif de supervision comporte un organe de calcul propre à comparer la tension mesurée de chaque conducteur de phase avec un seuil de surtension et un seuil de sous-tension prédéfinis.

L'invention a également pour objet un poste de transformation électrique destiné à être connecté à un réseau électrique alternatif polyphasé, le poste de transformation comprenant :
- un premier tableau comportant P conducteurs électriques d'arrivée propres à être relié au réseau électrique, P étant un nombre entier supérieur à 1,
- un deuxième tableau comportant au moins un départ de P conducteurs électriques et un conducteur de neutre,
- un transformateur électrique connecté entre le premier tableau et le deuxième tableau et propre à transformer un courant arrivant sur les conducteurs d'arrivée et présentant une première tension alternative en un courant présentant une deuxième tension alternative, et
- un système de détection d'une variation d'impédance du conducteur de neutre, caractérisé en ce que le système de détection est tel que défini ci-dessus.

L'invention a également pour objet un procédé de détection d'une variation d'impédance d'un conducteur de neutre d'un réseau électrique alternatif polyphasé, le réseau électrique comportant P conducteurs de phase et un conducteur de neutre, P étant un nombre entier supérieur à 1, le procédé comprenant les étapes suivantes :
- la mesure, par un groupe de P capteurs de tension en un emplacement donné du réseau électrique, de la tension de chaque conducteur de phase par rapport au conducteur de neutre,
- la transmission des tensions mesurées à un dispositif de supervision, de la part du groupe de capteurs de tension,
le procédé étant caractérisé en ce que, lors de l'étape de mesure, la tension de chaque conducteur de phase par rapport au conducteur de neutre est mesurée en différents emplacements le long du réseau électrique, par N groupes de P capteurs de tension disposés auxdits différents emplacements, et en ce que le procédé comprend en outre l'étape suivante :
- la détection, entre deux groupes successifs de capteurs, d'une variation de la tension d'un conducteur de phase donné par rapport au conducteur de neutre, afin de détecter une variation d'impédance du conducteur de neutre et de localiser ladite variation d'impédance entre les deux groupes successifs de capteurs, l'étape de détection étant réalisée par le dispositif de supervision à partir des tensions mesurées transmises par chacun des groupes de capteurs de tension.

Suivant un autre aspect avantageux de l'invention, le procédé de détection de variation d'impédance du conducteur de neutre comprend les caractéristiques suivantes :
- après avoir reçu un message d'alerte de la part d'un capteur de tension d'un groupe donné, en cas de détection d'une anomalie en tension, telle qu'une surtension ou une sous-tension, pour au moins un conducteur de phase, le dispositif de supervision émet des requêtes aux différents capteurs de tension du groupe donné, afin de recevoir en réponse les tensions mesurées par les capteurs du groupe donné ;
- après avoir reçu les tensions mesurées par les capteurs du groupe donné, le dispositif de supervision vérifie si à la fois une surtension pour un conducteur de phase et une sous-tension pour les autres conducteurs de phase sont détectées ;
- après avoir reçu les tensions mesurées par les capteurs du groupe donné, le dispositif de supervision vérifie que l'anomalie en tension détectée n'est pas due à la perte de l'une des phases du réseau ou à un déséquilibre de charge entre les phases du réseau ;
- après avoir reçu un message d'alerte de la part d'un capteur de tension d'un groupe donné, le dispositif de supervision émet en outre des requêtes aux différents capteurs de tension du ou des groupes adjacents au groupe donné
- le dispositif de supervision détermine le ou les groupes de capteurs détectant l'anomalie en tension et celui ou ceux ne la détectant pas, et détermine une zone de variation d'impédance se situant ente le dernier groupe de capteurs ne visualisant pas l'anomalie et le premier groupe de capteurs visualisant l'anomalie.

Ces caractéristiques et avantages de l'invention apparaîtront à la lecture de la description qui va suivre, donnée uniquement à titre d'exemple non limitatif, et faite en référence aux dessins annexés, sur lesquels :
- la figure 1 est une représentation schématique d'un poste de transformation électrique relié à un réseau électrique alternatif triphasé, le poste de transformation comportant un système de détection de variation selon l'invention ;
- la figure 2 est une vue à plus grande échelle de la zone II de la figure 1 ;
- la figure 3 est un organigramme d'un procédé de détection d'une variation d'impédance sur un conducteur de neutre du réseau électrique.

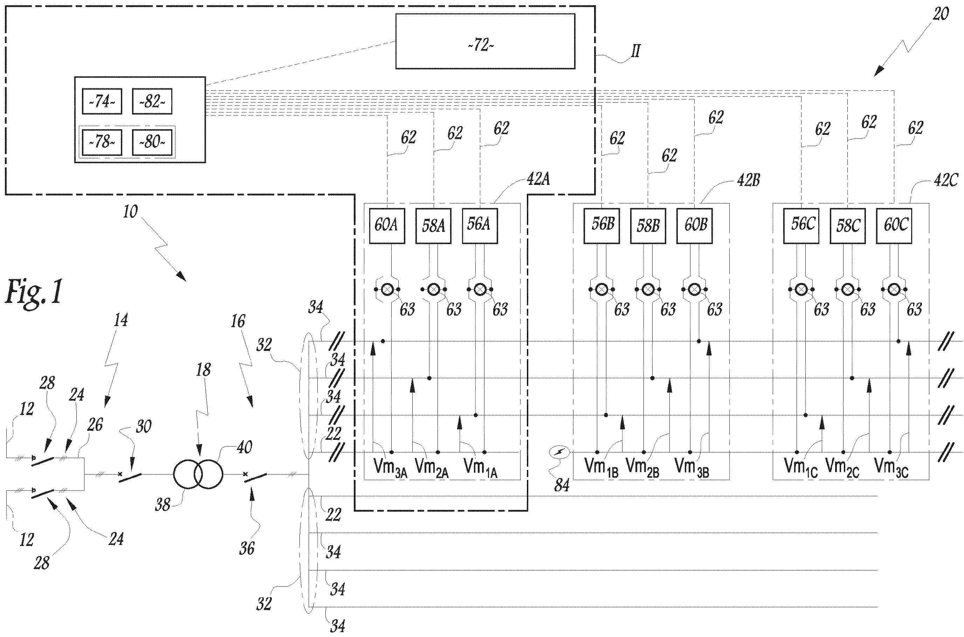

Sur la figure 1, un poste de transformation 10 connecté à un réseau électrique alternatif 12 comprend un premier tableau moyenne tension 14, un deuxième tableau basse tension 16, un transformateur électrique 18 connecté entre le premier tableau et le deuxième tableau et un système 20 de détection d'une variation d'impédance d'un conducteur de neutre 22.

Le poste de transformation 10 est propre à transformer le courant électrique délivré par le réseau 12 et présentant une première tension alternative, en un courant électrique présentant une deuxième tension alternative.

Le réseau électrique 12 est un réseau alternatif polyphasé comportant P phases, P étant un nombre entier supérieur à 1, tel qu'un réseau triphasé. Autrement dit, dans le mode de réalisation décrit, P est égal à 3.

Le réseau électrique 12 est un réseau moyenne tension, c'est-à-dire un réseau dont la tension est supérieure à 1 000 Volts et inférieure à 50 000 Volts. La première tension triphasée est alors une moyenne tension.

Le premier tableau 14 comporte plusieurs arrivées 24, chaque arrivée 24 comportant P conducteurs électriques d'arrivée 26, P étant un nombre entier supérieur à 1, et un interrupteur sectionneur 28.

Le premier tableau 14 comporte un disjoncteur d'arrivée 30 connecté entre le transformateur 18 et les arrivées 24.

Le deuxième tableau 16 comprend une pluralité de départs 32, chaque départ 32 étant propre à délivrer la deuxième tension alternative et comportant P conducteurs électriques de départ 34 et le conducteur de neutre 22.

Le deuxième tableau 16 comprend un disjoncteur de départ 36 connecté entre le transformateur 18 et les départs 32.

Le transformateur électrique 18 est propre à transformer le courant issu du réseau électrique présentant la première tension alternative en le courant délivré au deuxième tableau 16 et présentant la deuxième tension alternative. Le transformateur électrique 18 comporte un enroulement primaire 38 connecté au premier tableau 14 et un enroulement secondaire 40 connecté au deuxième tableau 16.

Le système de détection 20 est propre à détecter une variation d'impédance du conducteur de neutre 22 le long de celui-ci.

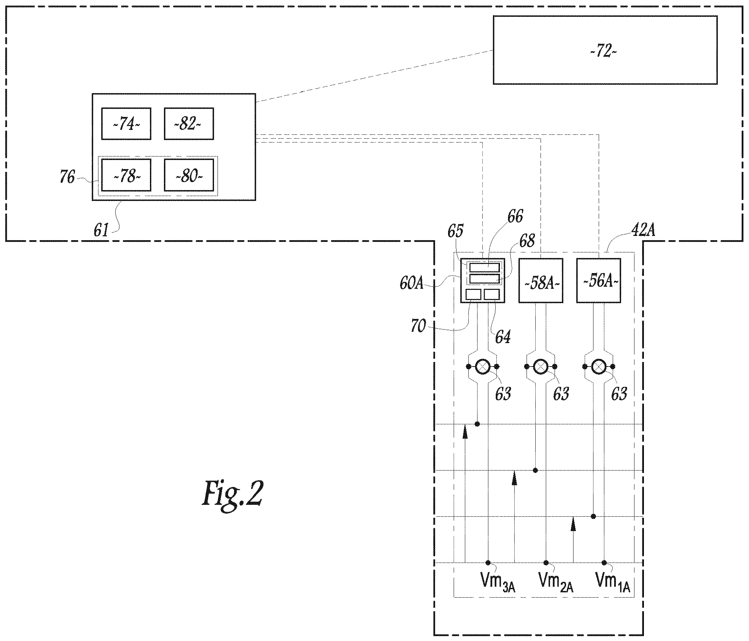

Le système de détection 20 comprend N groupes 42A, 42B, ..., 42N de capteurs de tension dont trois groupes successifs 42A, 42B, 42C sont représentés sur la figure 1, et dont un groupe 42A est visible à plus grande échelle sur la figure 2. Chacun de ces N groupes comporte P capteurs, par exemple 56A, 58A, 60A pour le groupe 42A, pour la mesure de chacune des tensions des P conducteurs de phase par rapport au conducteur de neutre 22. Dans le mode de réalisation décrit à la figure 1, chaque groupe 42A, 42B, 42C est constitué de P capteurs de tension 56A, 58A, 60A, 56B, 58B, 60B, 56C, 58C, 60C.

Ainsi, N capteurs de tensions sont répartis le long de chaque conducteur de départ 34 et sont propres à mesurer la tension de chaque conducteur de phase 34 par rapport au conducteur de neutre 22 en N points différents. C'est le cas par exemple des capteurs de tension 56A, 56B, 56C pour les mesures en tension de la première phase.

Le système de détection 20 comprend un dispositif de supervision 61 relié à chacun des capteurs de tension 56A, ..., 60C par une liaison de données 62.

Chaque départ 32 est un départ basse tension, c'est-à-dire un départ dont la tension est inférieure à 1000 Volts. La deuxième tension triphasée est alors une basse tension.

Chacun des conducteurs de phase 34 transporte l'énergie électrique vers des charges 63 des consommateurs se situant le long du réseau électrique. Certaines de ces charges, notamment celles comportant des circuits électroniques, sont sensibles aux variations de tension du réseau électrique.

Chacun des capteurs de tension 56A, ..., 60N comprend un processeur 64 et une mémoire 65 associée au processeur 64. La mémoire 65 est apte à stocker un premier logiciel de communication 66 et un premier logiciel de calcul 68.

Dans un mode de réalisation, chaque capteur 56A, ..., 60N comporte un émetteur-récepteur radioélectrique 70 propre à communiquer dans les deux directions avec le dispositif de supervision 61, chaque liaison de données 62 étant alors une liaison radioélectrique de données.

En variante, chaque capteur 56A, ..., 60N comporte un injecteur CPL, non représenté, propre à communiquer dans les deux directions avec le dispositif de supervision 61, chaque liaison de données 62 étant alors une liaison de transfert de données via un courant porteur en ligne.

Le dispositif de supervision 61 du système de détection 20 est propre à communiquer, d'une part avec les capteurs de tension 56A, ..., 60N, d'autre part avec un centre de contrôle 72.

Le dispositif de supervision 61 comprend un processeur 74 et une mémoire 76 associée au processeur 74. La mémoire 76 est apte à stocker un deuxième logiciel de communication 78 et un deuxième logiciel de calcul 80.

Dans le mode de réalisation, le dispositif de supervision 61 comporte un émetteur-récepteur radioélectrique 82 propre à communiquer, d'une part avec chacun des capteurs et, d'autre part, avec le centre de contrôle 72. Dans ce mode de réalisation, le centre de contrôle 72 comprend également un émetteur-récepteur, non représenté, propre à communiquer avec le dispositif de supervision 61. En variante, les communications décrites précédemment utilisent une liaison de transfert de données via un courant porteur en ligne.

Le premier logiciel de communication 66 est apte à établir une communication entre chaque capteur de tension 56A, ..., 60N et le dispositif de supervision 61. Le premier logiciel de communication 66 est notamment apte à envoyer un message d'alerte à destination du dispositif de supervision 61 en cas de détection d'une surtension ou d'une sous-tension par le premier logiciel du calcul 68 et pour au moins un conducteur de phase 34.

Le premier logiciel du calcul 68 est apte à détecter une surtension ou une sous-tension mesurée par un capteur de tension 56A, ..., 60N donné, à partir d'un seuil de surtension et de sous-tension prédéfinis. Le premier logiciel du calcul 68 est notamment apte à comparer la tension mesurée avec un seuil de surtension et un seuil de sous-tension prédéfinis, afin de détecter ladite surtension ou sous-tension.

En variante, les capteurs de tension 56A, ..., 60N communiquent directement les tensions mesurées au dispositif de supervision 61 qui, à l'aide du deuxième logiciel de calcul 80, est apte à déterminer les capteurs de tension 56A, ..., 60N mesurant une surtension ou une sous-tension par rapport à des seuils prédéfinis.

Ces deux logiciels 66 et 68 sont aptes à communiquer entre eux. Ainsi, la détection d'une anomalie en tension détectée par le premier logiciel de calcul 68 entraîne l'émission d'une alerte par le premier logiciel de communication 66 en direction du dispositif de supervision 61.

Le deuxième logiciel de communication 78 est apte à établir la communication entre le dispositif de supervision 61 et les différents capteurs de tension du réseau 56A, ..., 60N, et entre le dispositif de supervision 61 et le centre de contrôle 72. Le deuxième logiciel de communication 78 est apte à envoyer des requêtes à chacun des capteurs de tension 56A, ..., 60N afin de recevoir en réponse la tension mesurée par chacun de ces capteurs.

Le deuxième logiciel de calcul 80 est apte, à partir des données communiquées par les capteurs de tension 56A, ..., 60N, à déterminer une anomalie de sous-tension ou de surtension avec un seuil de surtension et un seuil de sous-tension prédéfinis.

En variante, lorsque les capteurs de tension 56A, ..., 60N communiquent directement les tensions mesurées au dispositif de supervision 61, le deuxième logiciel de calcul 80 compare les tensions mesurées, reçues des capteurs de tension 56A, ..., 60N, avec un seuil de surtension et un seuil de sous-tension prédéfinis, afin de détecter une surtension ou une sous-tension.

Une variation d'impédance 84 sur le conducteur de neutre 22 est représentée sur la figure 1. La variation d'impédance 84 correspond, par exemple, à une rupture du conducteur de neutre, ou encore à une dégradation d'un contact du conducteur de neutre.

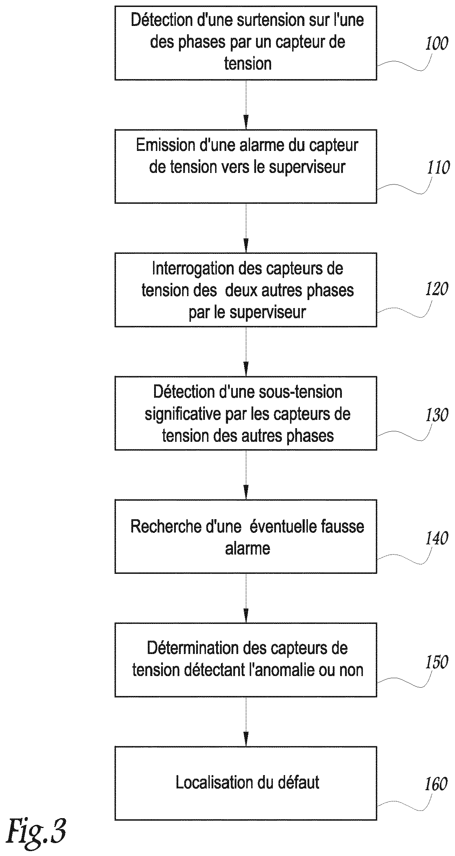

Le fonctionnement du système de détection va désormais être expliqué à l'aide de la figure 3. La figure 3 représente un organigramme des étapes d'un procédé de détection mis en oeuvre par le système de détection 20 comprenant les N groupes 42A, ..., 42N de capteurs de tension répartis le long des conducteurs de départ 34, ainsi que par le dispositif de supervision 61.

Sur la figure 3, lors de la première étape 100, un capteur de tension, par exemple le capteur 56B, détecte la présence d'une surtension sur l'un des conducteurs de phase 34. La détection de la surtension correspond, par exemple, à une tension mesurée entre le conducteur de phase 34 et le conducteur de neutre 22 supérieure de 10% à la tension nominale de ce même conducteur de phase 34 par rapport au conducteur de neutre 22, soit 110% de la tension nominale, à savoir environ 260V dans l'exemple de réalisation de la figure 1.

Après la détection d'une surtension sur l'un des conducteurs de phase 34, le capteur de tension détectant l'anomalie émet, lors de l'étape 110, une alarme en direction du dispositif de supervision 61.

Dès la réception de l'alarme, le dispositif de supervision 61 interroge les deux capteurs de tension 58B, 60B appartenant au même groupe 42B que le capteur 56B ayant détecté l'anomalie.

Lors de l'étape 130, le dispositif de supervision 32 vérifie que la surtension détectée sur l'un des capteurs de tension, tel que le capteur 56B dans l'exemple de la figure 1, se fait en parallèle d'une sous-tension mesurée sur les deux autres capteurs de tension du groupe 42B, tels que les capteurs 58B et 60B. Dans le cas d'un réseau triphasé et pour un seuil de surtension prédéterminé, égal à 110% de la tension nominale, le dispositif de supervision 61 vérifie qu'une sous-tension d'au moins 5% est observée par l'un des capteurs de tension 58B, 60B associé à aux deux autres conducteurs de phase. Autrement dit, le dispositif de supervision 61 vérifie qu'au moins un capteur de tension 58B, 60B du même groupe 42B que le capteur 46B ayant détecté la surtension mesure une tension inférieure à 95% de la tension nominale correspondante, à savoir 228V dans l'exemple de réalisation de la figure 1.

A la suite de l'étape 130, l'étape 140 consiste à vérifier que les détections précédentes sont bien représentatives d'une variation d'impédance, telle qu'une rupture du neutre. En d'autres termes l'étape 140 consiste en la recherche d'une éventuelle fausse alarme. En particulier, le dispositif de supervision 61 vérifie que la détection d'anomalie en tension n'est pas due à la perte d'une des phases du réseau d'alimentation en moyenne tension, auquel cas le phénomène de surtension d'un des conducteurs de phase 34 se retrouve au niveau du deuxième tableau 16 en basse tension, et les deux autres conducteurs de phase présentent des sous-tensions de l'ordre de 50%.

Dans certains cas, la présence d'une production décentralisée d'énergie en ligne, via des panneaux photovoltaïques par exemple, entraîne une surtension de l'ordre de 10% sur l'une des phases du réseau. A l'inverse, dans certains cas, la présence d'une charge importante sur l'une des phases du réseau entraîne une sous-tension de l'ordre de 5% à 10% sur les autres phases du réseau. Dans un mode de réalisation, le dispositif de supervision 61 mesure les courants circulants sur chacune des phases, ainsi que l'ensemble des puissances produites ou consommées sur ces mêmes phases. Il discrimine alors les anomalies en tension dues aux productions décentralisées et à la présence d'une ou plusieurs charge(s) importante(s) sur réseau de celles dues à une dégradation d'un conducteur de neutre. En outre, la dégradation d'un conducteur de neutre se distingue par le fait qu'elle entraîne une variation soudaine des tensions des phases du réseau.

Suite à la détection d'une anomalie en tension représentative d'une variation d'impédance du neutre 84 lors de l'étape 140, l'étape 150 vise à déterminer le dernier capteur 56A ne visualisant pas la variation d'impédance et le premier capteur 56B visualisant la variation d'impédance.

Pour ce faire, après la mesure en tension d'une anomalie sur l'un des conducteurs de phase 34, puis après l'alerte du dispositif de supervision 61 par le capteur de tension 56B, le dispositif de supervision 61 interroge les groupes de capteurs 42A, 42C adjacents aux capteurs 56B, 58B, 60B. Si l'un de ces groupes de capteurs ne mesure pas l'anomalie, tel que le groupe 42A, le dispositif de supervision 61 en déduit que la localisation de la variation d'impédance se situe entre le groupe 42B ayant mesuré l'anomalie et le groupe 42A interrogé ne l'ayant pas mesuré.

Dans le cas où les groupes interrogés mesurent également l'anomalie, le dispositif de supervision 61 interroge de nouveau les groupes adjacents en amont et en aval des groupes précédemment interrogés. Ainsi, l'interrogation de manière récursive des groupes de capteurs se situant en amont et en aval du premier groupe 42B ayant mesuré l'anomalie permet, après un certain nombre d'interrogations, de localiser le premier groupe 42A de capteurs ne mesurant pas l'anomalie en tension.

Finalement, lors de l'étape 160, la zone de variation d'impédance est localisée par la zone se situant entre le dernier capteur ne visualisant pas d'anomalie 56A en tension et le premier capteur visualisant une anomalie en tension 56B.

La localisation ainsi réalisée par le dispositif de supervision 61, l'information de localisation de l'anomalie est envoyée au centre de contrôle 72 afin de permettre la planification d'une maintenance sur le réseau.

Le système de détection selon l'invention permet ainsi non seulement de détecter une variation d'impédance, telle qu'une rupture du neutre, mais également de localiser la zone de cette variation d'impédance le long du réseau basse tension du fait de l'agencement des N groupes 42A, ..., 42N de capteurs de tension le long du réseau basse tension.

En outre, la communication entre chaque capteur de tension 56A, ..., 60N et le dispositif de supervision 61 permet de différencier les anomalies en tension liées à la structure du réseau moyenne tension 12 des anomalies en tension dues à une variation d'impédance 84 nécessitant une maintenance.

Le système et le procédé selon l'invention permettent ainsi de détecter une dégradation d'un conducteur de neutre avant sa rupture, permettant une maintenance préventive sur le réseau.

Une intervention sur le réseau basse tension est alors réalisée avant qu'une rupture franche du neutre 22 ne se produise et n'endommage ou ne détruise des charges 63 connectées au réseau basse tension. Cela permet alors d'éviter la dégradation de ces charges.

L'utilisation d'un tel dispositif et d'un tel procédé permet également l'utilisation de capteurs de tension 56A, ..., 60N comportant des émetteurs-récepteurs radioélectriques 70, évitant ainsi le déplacement de personnel pour assurer les relevés.

Un tel dispositif et un tel procédé selon l'invention permettent également à la suite de la localisation du défaut 84 sur le réseau électrique, d'envoyer une alarme du dispositif de supervision 61 vers le centre de contrôle 72 avec l'information de localisation associée audit défaut 84. Le centre de contrôle 72 envoie alors une équipe de maintenance afin de vérifier l'état des connexions du conducteur de neutre 22 dans une zone ciblée et préalablement localisée.

Les équipes de maintenance optimisent ainsi la disponibilité de leurs ressources pour la maintenance de la zone de variation d'impédance. Cette optimisation est rendue possible car les opérateurs de maintenance peuvent se rendre directement sur la zone de variation d'impédance, sans perdre de temps à rechercher cette zone.

On conçoit ainsi que le système de détection selon l'invention permet non seulement la détection, mais également la localisation d'une variation d'impédance sur le réseau, telle qu'une rupture du neutre, via la surveillance en tension le long du réseau électrique

## Revendications

1. Système (20) de détection d'une variation d'impédance (84) d'un conducteur de neutre (22) d'un réseau électrique alternatif polyphasé, le réseau électrique comportant P conducteurs de phase (34) et un conducteur de neutre (22), P étant un nombre entier supérieur à 1, le système comprenant :
- un groupe (42A) de P capteurs de tension (56A, 58A, 60A), chaque capteur de tension (56A, 58A, 60A) étant propre à mesurer la tension d'un conducteur de phase (34) respectif par rapport au conducteur de neutre (22), et
- un dispositif de supervision (61) relié à chacun des capteurs (56A, 58A, 60A) de tension par une liaison de données (62),
**caractérisé en ce que** le système comprend en outre (N-1) autre(s) groupe(s) (42B, ..., 42N) de P capteurs de tension (56B, 58B, 60B, ..., 56N, 58N, 60N), N étant un nombre entier supérieur à 1, les N groupes de capteurs de tension (42A, ..., 42N) étant disposés en différents emplacements le long du réseau électrique, et
**en ce que** le dispositif de supervision (61) est propre à détecter, entre deux groupes successifs de capteurs (42A, 42B), une variation de la tension d'un conducteur de phase (34) donné par rapport au conducteur de neutre (22), afin de détecter une variation (84) d'impédance du conducteur de neutre (22) et de localiser ladite variation d'impédance (84) entre les deux groupes successifs de capteurs (42A, 42B).

2. Système (20) selon la revendication 1, **caractérisé en ce que** chaque capteur de tension (56A, ...,60N) comporte des moyens d'émission (66) d'un message d'alerte à destination du dispositif de supervision (61) en cas de détection d'une surtension ou d'une sous-tension pour au moins un conducteur de phase (34).

3. Système (20) selon la revendication 1 ou 2, **caractérisé en ce que** chaque capteur de tension (56A, ...,60N) comporte des moyens (68) de comparaison de la tension mesurée avec un seuil de surtension et un seuil de sous-tension prédéfinis, afin de détecter une surtension ou une sous-tension.

4. Système (20) selon la revendication 1 ou 2, **caractérisé en ce que** le dispositif de supervision (61) comporte des moyens (80) de comparaison de la tension mesurée, reçue d'un capteur de tension (56A, ...,60N) correspondant, avec un seuil de surtension et un seuil de sous-tension prédéfinis, afin de détecter une surtension ou une sous-tension.

5. Système (20) selon l'une quelconque des revendications précédentes, **caractérisé en ce que** le dispositif de supervision (61) comporte des moyens de communication (78) avec chacun des capteurs de tension (56A, ...,60N), aptes à envoyer une requête à chacun des capteurs de tension afin de recevoir en réponse la tension mesurée par chaque capteur de tension.

6. Système (20) selon l'une quelconque des revendications précédentes, **caractérisé en ce que** le dispositif de supervision (61) comporte un organe de calcul (80) propre à comparer la tension mesurée de chaque conducteur de phase (34) avec un seuil de surtension et un seuil de sous-tension prédéfinis.

7. Poste de transformation électrique (10) destiné à être connecté à un réseau électrique alternatif polyphasé (12), le poste de transformation comprenant
- un premier tableau (14) comportant P conducteurs électriques d'arrivée (26) propres à être relié au réseau électrique (12), P étant un nombre entier supérieur à 1,
- un deuxième tableau (16) comportant au moins un départ (32) de P conducteurs électriques et un conducteur de neutre (22),
- un transformateur électrique (18) connecté entre le premier tableau (14) et le deuxième tableau (16) et propre à transformer un courant arrivant sur les conducteurs d'arrivée (26) et présentant une première tension alternative en un courant présentant une deuxième tension alternative, et
- un système (20) de détection d'une variation (84) d'impédance du conducteur de neutre (22),
**caractérisé en ce que** le système de détection (20) est conforme à l'une quelconque des revendications précédentes.

8. Procédé de détection d'une variation (84) d'impédance d'un conducteur de neutre (22) d'un réseau électrique alternatif polyphasé, le réseau électrique comportant P conducteurs de phase (34) et le conducteur de neutre (22), P étant un nombre entier supérieur à 1, le procédé comprenant les étapes suivantes :
- la mesure, par un groupe (42A) de P capteurs de tension (56A, 58A, 60A) en un emplacement donné du réseau électrique, de la tension de chaque conducteur de phase (34) par rapport au conducteur de neutre (22),
- la transmission des tensions mesurées à un dispositif de supervision (61), de la part du groupe de capteurs de tension (42A),
le procédé étant **caractérisé en ce que**, lors de l'étape de mesure, la tension de chaque conducteur de phase (34) par rapport au conducteur de neutre (22) est mesurée en différents emplacements le long du réseau électrique, par N groupes (42A, ..., 42N) de P capteurs de tension (56A, ...,60N) disposés auxdits différents emplacements, et
**en ce que** le procédé comprend en outre l'étape suivante :
- la détection (100), entre deux groupes successifs de capteurs, d'une variation de la tension d'un conducteur de phase (34) donné par rapport au conducteur de neutre (22), afin de détecter la variation d'impédance (84) du conducteur de neutre (22) et de localiser ladite variation d'impédance (84) entre les deux groupes successifs de capteurs (42A, 42B), l'étape de détection étant réalisée par le dispositif de supervision (61) à partir des tensions mesurées transmises par chacun des groupes de capteurs de tension (42A, ..., 42N).

9. Procédé selon la revendication 8, **caractérisé en ce que**, après avoir reçu un message d'alerte de la part d'un capteur de tension (56B) d'un groupe donné (42B), en cas de détection d'une anomalie en tension, telle qu'une surtension ou une sous-tension, pour au moins un conducteur de phase (34), le dispositif de supervision (61) émet des requêtes aux différents capteurs de tension (56B, 58B, 60B) du groupe donné (42B), afin de recevoir en réponse les tensions mesurées par les capteurs du groupe donné (42B).

10. Procédé selon la revendication 9, **caractérisé en ce que**, après avoir reçu les tensions mesurées par les capteurs (56B, 58B, 60B) du groupe donné (42B), le dispositif de supervision (61) vérifie si à la fois une surtension pour un conducteur de phase (34) et une sous-tension pour les autres conducteurs de phase (34) sont détectées.

11. Procédé selon la revendication 9 ou 10, **caractérisé en ce que**, après avoir reçu les tensions mesurées par les capteurs du groupe donné (42B), le dispositif de supervision (61) vérifie que l'anomalie en tension détectée n'est pas due à la perte de l'une des phases du réseau ou à un déséquilibre de charge entre les phases du réseau.

12. Procédé selon l'une quelconque des revendications 9 à 11, **caractérisé en ce que**, après avoir reçu un message d'alerte de la part d'un capteur de tension d'un groupe donné (42B), le dispositif de supervision (61) émet en outre des requêtes aux différents capteurs de tension du ou des groupes (42A, 42C) adjacents au groupe donné (42B).

13. Procédé selon la revendication 12, **caractérisé en ce que** le dispositif de supervision (61) détermine le ou les groupes de capteurs (42B, 42C) détectant l'anomalie en tension et celui (42A) ou ceux ne la détectant pas, et détermine une zone de variation d'impédance se situant entre le dernier groupe de capteurs (42A) ne visualisant pas l'anomalie et le premier groupe de capteurs (42B) visualisant l'anomalie.

## Patentansprüche

1. System (20) zum Detektieren einer Impedanzänderung (84) eines Neutralleiters (22) eines mehrphasigen elektrischen Wechselstromnetzes, wobei das elektrische Netz P Phasenleiter (34) und einen Neutralleiter (22) aufweist, wobei P eine ganze Zahl größer als 1 ist, wobei das System umfasst:
- eine Gruppe (42A) von P Spannungssensoren (56A, 58A, 60A,), wobei jeder Spannungssensor (56A, 58A, 60A) geeignet ist, die Spannung eines jeweiligen Phasenleiters (34) in Bezug auf den Neutralleiter (22) zu messen, und
- eine Überwachungsvorrichtung (61), die an jeden der Spannungssensoren (56A, 58A, 60A) durch eine Datenverbindung (62) angeschlossen ist,
**dadurch gekennzeichnet, dass** das System außerdem (N -1) andere Gruppen (42B, ..., 42N) von P Spannungssensoren (56B, 58B, 60B, ..., 56N, 58N, 60N) umfasst, wobei N eine ganze Zahl größer als 1 ist, wobei die N Gruppen (42A, ..., 42N) von Spannungssensoren an unterschiedlichen Stellen entlang des elektrischen Netzes angeordnet sind, und
dass die Überwachungsvorrichtung (61) geeignet ist, zwischen zwei aufeinanderfolgenden Gruppen (42A, 42B) von Sensoren eine Spannungsänderung eines gegebenen Phasenleiters (34) in Bezug auf den Neutralleiter (22) zu detektieren, um eine Impedanzänderung (84) des Neutralleiters (22) zu detektieren und die Impedanzänderung (84) zwischen den zwei aufeinanderfolgenden Gruppen (42A, 42B) von Sensoren zu lokalisieren.

2. System (20) nach Anspruch 1, **dadurch gekennzeichnet, dass** jeder Spannungssensor (56A, ..., 60N) Mittel (66) zum Senden einer Alarmnachricht an die Überwachungsvorrichtung (61) im Fall des Detektierens einer Überspannung oder einer Unterspannung für mindestens einen Phasenleiter (34) aufweist.

3. System (20) nach Anspruch 1 oder 2, **dadurch gekennzeichnet, dass** jeder Spannungssensor (56A, ..., 60N) Mittel (68) zum Vergleichen der gemessenen Spannung mit einer vordefinierten Überspannungsschwelle und Unterspannungsschwelle aufweist, um eine Überspannung oder eine Unterspannung zu detektieren.

4. System (20) nach Anspruch 1 oder 2, **dadurch gekennzeichnet, dass** die Überwachungsvorrichtung (61) Mittel (80) zum Vergleichen der gemessenen Spannung, die von einem entsprechenden Spannungssensor (56A, ..., 60N) empfangenen wird, mit einer vordefinierten Überspannungsschwelle und Unterspannungsschwelle aufweist, um eine Überspannung oder eine Unterspannung zu detektieren.

5. System (20) nach einem beliebigen der vorhergehenden Ansprüche, **dadurch gekennzeichnet, dass** die Überwachungsvorrichtung (61) Mittel (78) zum Kommunizieren mit einem der Spannungssensoren (56A, ..., 60N) aufweist, die geeignet sind, eine Anfrage an jeden der Spannungssensoren zu senden, um als Antwort die von jedem Spannungssensor gemessene Spannung zu empfangen.

6. System (20) nach einem beliebigen der vorhergehenden Ansprüche, **dadurch gekennzeichnet, dass** die Überwachungsvorrichtung (61) ein Rechenelement (80) aufweist, das geeignet ist, die gemessene Spannung jedes Phasenleiters (34) mit einer vordefinierten Überspannungsschwelle und einer Unterspannungsschwelle zu vergleichen.

7. Umspannstation (10), die vorgesehen ist, mit einem mehrphasigen elektrischen Wechselstromnetz (12) verbunden zu werden, wobei die Umspannstation umfasst:
- eine erste Schalttafel (14), die P elektrische Zuführungsleitungen (26) aufweist, die geeignet sind, an das elektrische Netz (12) angeschlossen zu werden, wobei P eine ganze Zahl größer als 1 ist,
- eine zweite Schalttafel (16), die mindestens einen Abgang von P elektrischen Leitern und einem Neutralleiter (22) aufweist,
- einen elektrischen Transformator (18), der zwischen die erste Schalttafel (14) und die zweite Schalttafel (16) geschaltet ist und geeignet ist, einen auf den Zuführungsleitungen (26) ankommenden Strom, der eine erste Wechselspannung aufweist, in einen Strom, der eine zweite Wechselspannung aufweist, zu transformieren, und
- ein System (20) zum Detektieren einer Impedanzänderung (84) des Neutralleiters (22),
**dadurch gekennzeichnet, dass** das System (20) zum Detektieren gemäß einem beliebigen der vorhergehenden Ansprüche ausgebildet ist.

8. Verfahren zum Detektieren einer Impedanzänderung (84) eines Neutralleiters (22) eines mehrphasigen elektrischen Wechselstromnetzes, wobei das elektrische Netz P Phasenleiter (34) und den Neutralleiter (22) aufweist, wobei P eine ganze Zahl größer als 1 ist, wobei das Verfahren die folgenden Schritte umfasst:
- Messen der Spannung jedes Phasenleiters (34) in Bezug auf den Neutralleiter (22) mit einer Gruppe (42A) von P Spannungssensoren (56A, 58A, 60A) an einer vorgegebenen Stelle des elektrischen Netzes,
- Übertragen der gemessenen Spannungen an eine Überwachungsvorrichtung (61) seitens der Gruppe (42A) von Spannungssensoren,
wobei das Verfahren **dadurch gekennzeichnet ist, dass** bei dem Meßschritt die Spannung jedes Phasenleiters (34) in Bezug auf den Neutralleiter (22) an verschiedenen Stellen entlang des elektrischen Netzes von N Gruppen (42A, ..., 42N) von P Spannungssensoren (56A, ..., 60N) gemessen wird, die an den verschiedenen Stellen angeordnet sind, und
- Detektieren (100) einer Änderung der Spannung eines vorgegebenen Phasenleiters (34) in Bezug auf den Neutralleiter (22) zwischen zwei aufeinanderfolgenden Gruppen von Sensoren, um die Impedanzänderung (84) des Neutralleiters (22) zu detektieren und die genannte Impedanzänderung (84) zwischen den zwei aufeinanderfolgenden Gruppen (42A, 42B) von Sensoren zu lokalisieren, wobei der Detektionsschritt von der Überwachungsvorrichtung (61) aus den gemessenen Spannungen, die von jeder der Gruppen (42A, ..., 42N) von Spannungssensoren übertragen werden, durchgeführt wird.

9. Verfahren nach Anspruch 8, **dadurch gekennzeichnet, dass** die Überwachungsvorrichtung (61), nachdem sie eine Alarmnachricht seitens eines Spannungssensors (56B) einer gegebenen Gruppe (42B) im Fall des Detektierens einer Spannungsanomalie, wie eine Überspannung oder eine Unterspannung, für mindestens einen Phasenleiter (34) empfangen hat, Anfragen an die unterschiedlichen Spannungssensoren (56B, 58B, 60B) der gegebenen Gruppe (42B) sendet, um in Antwort darauf die von den Sensoren der gegebenen Gruppe (42B) gemessenen Spannungen zu empfangen.

10. Verfahren nach Anspruch 9, **dadurch gekennzeichnet, dass** die Überwachungsvorrichtung (61), nachdem sie von den Sensoren (56B, 58B, 60B) der gegebenen Gruppe (42B) die gemessenen Spannungen empfangen hat, überprüft, ob sowohl eine Überspannung für einen Phasenleiter (34) als auch eine Unterspannung für die anderen Phasenleitern (34) detektiert werden.

11. Verfahren nach Anspruch 9 oder 10, **dadurch gekennzeichnet, dass** die Überwachungsvorrichtung (61), nachdem sie die von den Sensoren der gegebenen Gruppe (42B) gemessenen Spannungen empfangen hat, überprüft, dass die detektierte Spannungsanomalie nicht aufgrund des Verlustes einer der Phasen des Netzes oder einer Lastungleichheit zwischen den Phasen des Netzes begründet ist.

12. Verfahren nach einem beliebigen der Ansprüche 9 bis 11, **dadurch gekennzeichnet, dass** die Überwachungsvorrichtung (61), nachdem sie eine Alarmnachricht seitens eines Spannungssensors einer gegebenen Gruppe (42B) empfangen hat, außerdem Anfragen an die unterschiedlichen Spannungssensoren der einen oder mehreren Gruppen (42A, 42C) benachbart zur gegebenen Gruppe (42B) sendet.

13. Verfahren nach Anspruch 12, **dadurch gekennzeichnet, dass** die Überwachungsvorrichtung (61) die eine oder mehreren Gruppen (42B, 42C) von Sensoren, die die Spannungsanomalie detektiert haben, und diejenige (42A) oder diejenigen, die sie nicht detektieren, bestimmt und eine Zone der Impedanzänderung ermittelt, die zwischen der letzten Gruppe (42A) von Sensoren, die nicht die Anomalie anzeigt, und der ersten Gruppe (42B) von Sensoren, die die Anomalie anzeigt, liegt.

## Claims

1. System (20) for detecting impedance variation (84) in a neutral conductor (22) of a multiphase AC electrical network, the electrical network comprising P phase conductors (34) and one neutral conductor (22), where P is an integer greater than 1, the system comprising:
- a group (42A) of P voltage sensors (56A, 58A, 60A), each voltage sensor (56A, 58A, 60A) being suitable for measuring the voltage of a respective phase conductor (34) in relation to the neutral conductor (22), and
- a supervising device (61) connected to each of the voltage sensors (56A, 58A, 60A) via a data link (62),
**characterised in that** the system further comprises (N-1) other group(s) (42B, ..., 42N) of P voltage sensors (56B, 58B, 60B, ..., 56N, 58N, 60N), where N is an integer greater than 1, the N groups of voltage sensors (42A, ..., 42N) being arranged at different locations along the electrical network, and
**in that** the supervising device (61) is suitable for detecting, between two successive groups of sensors (42A, 42B), a variation in the voltage of a given phase conductor (34) in relation to the neutral conductor (22), in order to detect impedance variation (84) in the neutral conductor (22) and locate said impedance variation (84) between the two successive groups of sensors (42A, 42B).

2. System (20) according to claim 1, **characterised in that** each voltage sensor (56A, ...,60N) comprises means for transmitting (66) a warning message to the supervising device (61) in the event of overvoltage or undervoltage detection for at least one phase conductor (34).

3. System (20) according to claim 1 or 2, **characterised in that** each voltage sensor (56A, ...,60N) comprises means (68) for comparing the voltage measured with a predefined overvoltage threshold and undervoltage threshold, in order to detect an overvoltage or undervoltage.

4. System (20) according to claim 1 or 2, **characterised in that** the supervising device (61) comprises means (80) for comparing the voltage measured, received from a corresponding voltage sensor (56A, ...,60N), with a predefined overvoltage threshold and a predefined undervoltage threshold, in order to detect an overvoltage or an undervoltage.

5. System (20) according to any one of the preceding claims, **characterised in that** the supervising device (61) comprises means for communicating (78) with each of the voltage sensors (56A, ...,60N), suitable for transmitting a request to each of the voltage sensors in order to receive in response the voltage measured by each voltage sensor.

6. System (20) according to any one of the preceding claims, **characterised in that** the supervising device (61) comprises a calculating unit (80) suitable for comparing the measured voltage of each phase conductor (34) with a predefined overvoltage threshold and a predefined undervoltage threshold.

7. Electrical transformer station (10) to be connected to a multiphase AC electrical network (12), the transformer station comprising:
- a first board (14) comprising P electrical input conductors (26) suitable for being connected to the electrical network (12), where P is an integer greater than 1,
- a second board (16) comprising at least one output (32) of P electrical conductors and one neutral conductor (22),
- an electrical transformer (18) connected between the first board (14) and the second board (16) and suitable for transforming an incoming current on the input conductors (26) and having a first AC voltage into a current having a second AC voltage, and
- a system (20) for detecting impedance variation (84) in the neutral conductor (22),
**characterised in that** the detection system (20) is according to any one of the preceding claims.

8. Method for detecting impedance variation (84) in a neutral conductor (22) of a multiphase AC electrical network, the electrical network comprising P phase conductors (34) and the neutral conductor (22), where P is an integer greater than 1, the method comprising the following steps:
- measurement, by a group (42A) of P voltage sensors (56A, 58A, 60A) at a given location of the electrical network, of the voltage of each phase conductor (34) in relation to the neutral conductor (22),
- transmission of the voltages measured to a supervising device (61), from the group of voltage sensors (42A),
the method being **characterised in that**, during the measurement step, the voltage of phase conductor (34) in relation to the neutral conductor (22) is measured at different locations along the electrical network, by N groups (42A, ..., 42N) of P voltage sensors (56A, ...,60N) arranged at said various locations, and
**in that** the method further comprises the following step:
- detection (100), between two successive groups of sensors, of a voltage variation in a given phase conductor (34) in relation to the neutral conductor (22), in order to detect impedance variation (84) in the neutral conductor (22) and locate said impedance variation (84) between the two successive groups of sensors (42A, 42B), the detection step being performed by the supervising device (61) on the basis of the measured voltages transmitted by each of the groups of voltage sensors (42A, ..., 42N).

9. Method according to claim 8, **characterised in that**, after receiving a warning message from a voltage sensor (56B) of a given group (42B), in the event of the detection of a voltage anomaly, such as overvoltage or undervoltage, for at least one phase conductor (34), the supervising device (61) sends requests to the various voltage sensors (56B, 58B, 60B) of the given group (42B), in order to receive the voltages measured by the sensors of the given group (42B).

10. Method according to claim 9, **characterised in that**, after receiving the voltages measured by the sensors (56B, 58B, 60B) of the given group (42B), the supervising device (61) checks whether both an overvoltage for one phase conductor (34) and an undervoltage for the other phase conductors (34) are detected.

11. Method according to claim 9 or 10, **characterised in that**, after receiving the voltages measured by the sensors of the given group (42B), the supervising device (61) checks that the voltage anomaly detected is not caused by the loss of any of the phases of the network or by a load imbalance between the phases of the network.

12. Method according to any one of claims 9 to 11, **characterised in that**, after receiving a warning message from a voltage sensor of a given group (42B), the supervising device (61) further transmits requests to the various voltage sensors of the group(s) (42A, 42C) adjacent to the given group (42B).

13. Method according to claim 12, **characterised in that** the supervising device (61) determines the group(s) of sensors (42B, 42C) detecting the voltage anomaly and that (42A) or those not detecting it, and determines an impedance variation zone situated between the final group of sensors (42A) not indicating the anomaly and the first group of sensors (42B) indicating the anomaly.
